# EUROPEAN PATENT SPECIFICATION

(11) **EP 4 364 362 B1**
(45) Date of publication and mention of the grant of the patent: **09.12.2026**
(21) Application number: 22832262.4
(22) Date of filing: 27.06.2022
(51) Int. Cl.: H04N 21/436, H04N 21/4363, G06F 3/14, H04L 12/28, H04L 27/00

(54) **AUDIO VIDEO RECEIVER WITH SIMULTANEOUS MULTIZONE 8K VIDEO ROUTING**
AUDIO-VIDEO-EMPFÄNGER MIT GLEICHZEITIGER MEHRZONIGER 8K-VIDEO-LEITWEGLENKUNG
RÉCEPTEUR AUDIO VIDÉO AVEC ROUTAGE VIDÉO MULTIZONE 8K SIMULTANÉ

(30) Priority: 28.06.2021 US 202117360530
(43) Date of publication of application: 08.05.2024
(60) Divisional application: 26215458.6
(73) Proprietor: Lenbrook Industries Limited, Pickering, Ontario L1W 3K1 (CA)
(72) Inventor: STIDSEN, Gregory, R., Pickering, Ontario L1W 3K1 (CA); GROENEVELD, Kevin, Pickering, Ontario L1W 3K1 (CA)
(74) Representative: J A Kemp LLP
(86) International application number: PCT/IB2022/000362
(87) International publication number: WO 2023/275614

(56) References cited:
- EP-B1- 1 064 739
- CN-U- 212 909 766
- US-A1- 2005 046 748
- US-A1- 2009 257 360
- US-A1- 2011 209 190
- US-A1- 2015 043 888
- US-A1- 2016 140 075
- US-A1- 2016 140 075
- US-A1- 2018 191 653
- US-A1- 2018 316 875
- US-A1- 2021 274 347

## Description

### BACKGROUND

The present application relates generally to Audio Video Receivers (AVRs) and, more particularly, to simultaneous routing of video streams in AVRs between multiple inputs and outputs.

The first AVRs with fully digital video content capability were introduced to the consumer market shortly after 2000. Given the success of DVD and digital television at that time, AVRs with High-Definition Media Interface (HDMI) connections gained rapid consumer adoption. These first HDMI-enabled AVRs switched and routed content from digital media source devices and passed the content to one or more digital display devices. A fully digital video connection was a major advancement over previous AVRs with analog video connections, as digital AVRs preserved the video quality from the source through to the display. Over the following decade, the success of AVRs with HDMI increased competition among manufacturers to offer new AVR models offering higher digital video pixel resolutions. The initial resolution of 1080i ('interlaced') was quickly superseded by 1080p ('progressive'). AVR models with 4K video resolution capability are popular today. Fully professional camera and gaming of resolutions of 8K recently spurred the launch of the first AVR with a single 8K input. The vast quantities of data required for 8K video streams however cause immense design challenge for the design of the hardware electronics. Asides from the limitation of supporting 8K on only one single HDMI input, the market's first 8K AVR cannot route 8K video to display devices in secondary rooms of the home. This was a key feature of many previous AVRs in the market, as it enabled customers to view two different streams of video content in two different rooms of the home (e.g., a movie is displayed in the home theatre while a news channel is displayed in the kitchen). It would be desirable to connect multiple 8K video chipsets in a cost-effective manner that enables this essential 'multizone' video distribution feature. US 2016/140075 A1 discloses auto detection and adaptive configuration of HDMI ports. CN 212 909 766 U discloses a matrix switcher with HDBaseT technology.

### BRIEF SUMMARY OF THE DISCLOSURE

The invention is defined in the independent claims. Further aspects and preferred embodiments are defined in the dependent claims. Any aspects, embodiments and examples of the present disclosure which do not fall under the scope of the appended claims do not form part of the invention and are merely provided for illustrative purposes.

### BRIEF DESCRIPTION OF THE DRAWINGS

FIG. 1 is a diagram illustrating an exemplary AVR system in accordance with one or more embodiments.
FIG. 2 is a diagram illustrating an exemplary video-switching system in accordance with one or more embodiments.
FIG. 3 is a diagram illustrating connection of a controller in the video-switching system in accordance with one or more embodiments.
FIG. 4 is a diagram illustrating an exemplary video-switching system controller in accordance with one or more embodiments.
FIG. 5 is a flowchart illustrating exemplary operation of the video-switching system in accordance with one or more embodiments.

Like or identical reference numbers are used to identify common or similar elements.

### DETAILED DESCRIPTION

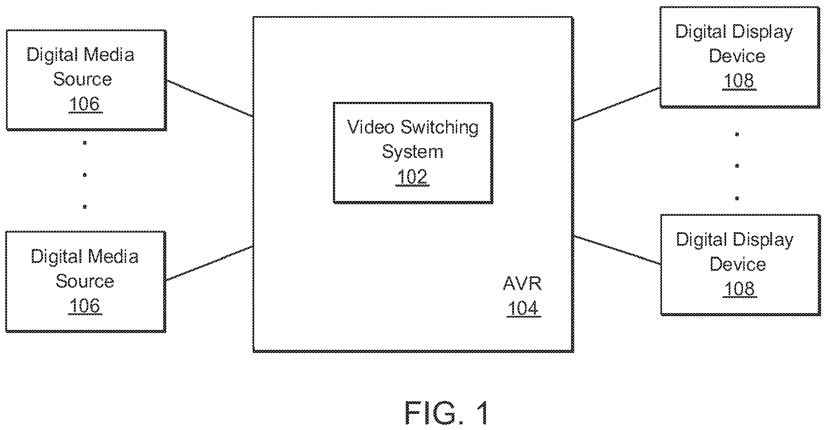

Various embodiments disclosed herein relate to a cost-effective video switching system 102, which can be part of an AVR 104 as depicted in FIG. 1. The video switching system enables simultaneous routing of multiple independent video streams (e.g., 8K video streams) received at HDMI inputs of the AVR 104 from digital media sources (DMS) 106 to multiple selected digital display devices 108.

Non-limiting examples of the digital display devices 108 include televisions and video projectors. Non-limiting examples of digital media sources 106 include set-top boxes, media streaming devices, digital cameras, Blu-ray and DVD players, and gaming consoles.

As discussed below, the video switching system 102 employs a novel video system architecture interconnecting multiple 8K video chips to realize simultaneous routing of multiple 8K video streams from the latest 8K video source devices to the newest 8K televisions and projectors. The system has reduced electronic hardware component cost and heat dissipation. The system is particularly advantageous for home theatre installations and multizone video distribution.

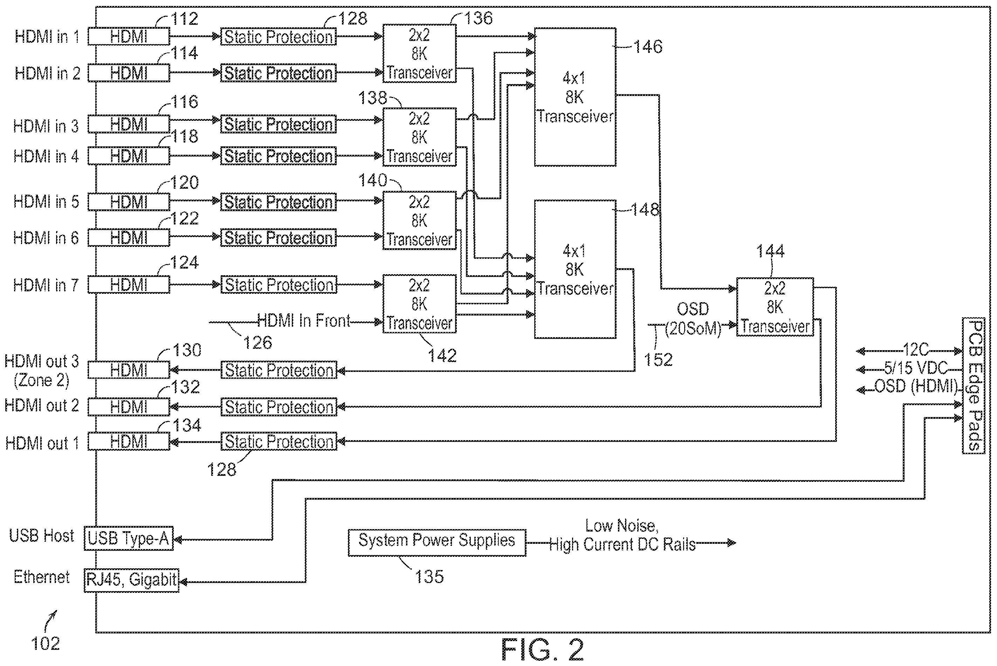

FIG. 2 illustrates the system architecture of an exemplary video-switching system 102 in accordance with one or more embodiments. This particular architecture features eight HDMI video inputs and three HDMI output connectors. It should be understood that the architecture could be adapted to include any number of inputs and outputs.

The system depicted in FIG. 2 is implemented in a single electric circuit board assembly. Implementation in multiple circuit board assemblies is also possible.

The exemplary video system architecture includes seven HDMI video inputs 112, 114, 116, 118, 120, 122, and 124. In addition, the system includes an eighth HDMI video input 126 at the front of the AVR console.

Each HDMI connector is coupled to a static protection device 128, which functions to prevent static electricity from damaging any of the sensitive and costly core components.

The exemplary system includes three HDMI output connectors 130, 132, 134.

A power supply 135 provides power for the video switching system 102.

The video management core of the system comprises seven specialized 8K video transceiver chips. Five of these transceivers are '2:2' (also referred to as '2X2') 136, 138, 140, 142, 144 and capable of routing two simultaneous video streams to either of its two outputs. The other two transceivers are '4:1' (also referred to as '4X1') 146, 148 and capable of routing one of four selected 8K video streams to one output.

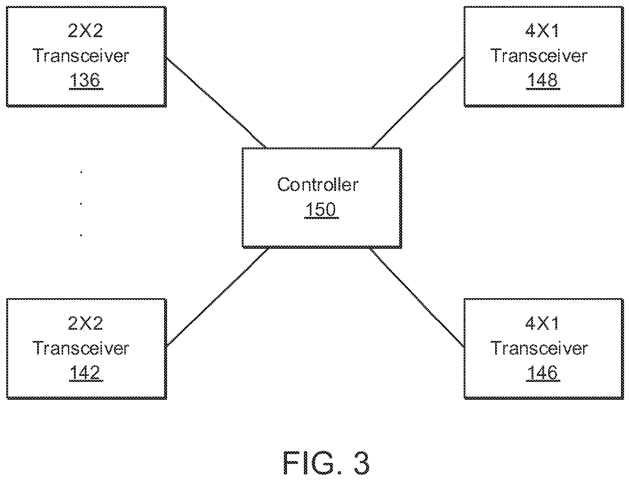

The operation of each of the seven transceiver chips is controlled by a controller 150 as depicted in FIG. 3. The controller 150 can be provided on the same or different circuit board assembly as the seven transceiver chips.

FIG. 2 depicts the interconnection among the seven transceivers. As shown in the diagram, these connections expand the system's input capability to accept any one of eight incoming video streams from the HDMI input connectors 112, 114, 116, 118, 120, 122, and 124. This is performed by four of the 2:2 transceivers 136, 138, 140, 142. The first output of each 2:2 transceiver 136, 138, 140, 142 is connected to an input of one 4:1 transceiver 146. The second output of each 2:2 transceiver 136, 138, 140, 142 is connected to an input of the second 4:1 transceiver 148. The second 4:1 transceiver 148 can pass any of one of the incoming video streams to the 'zone 2' HDMI output connector 130. The zone 2 output 130 is typically connected to a display device in a room or space remote from the main AVR system installation.

Simultaneously, the first 4:1 transceiver 146 may pass any one of the eight incoming video streams to a final 2:2 transceiver 144 in the tree. This last transceiver 144 may select any one of the incoming video streams to either or both of two HDMI output connectors 132, 134. These last two connectors 132, 134 are commonly referred to as the 'zone 1' or 'main zone' outputs and are typically connected to an 8K display projector and an 8K television.

The last 2:2 transceiver 144 may also select an 'on-screen display' (OSD) video stream 152 generated by the system's main host processor. When selected, this OSD presents a detailed graphical user interface on either or both of the main zone display devices to provide system setup and configuration features.

The above-described 'tree' system topology with the particular placement and connection of the two 4:1 transceivers 146, 148 provides a simultaneous or and non-blocking path for any two of the eight active 8K video streams from the system's inputs to its outputs.

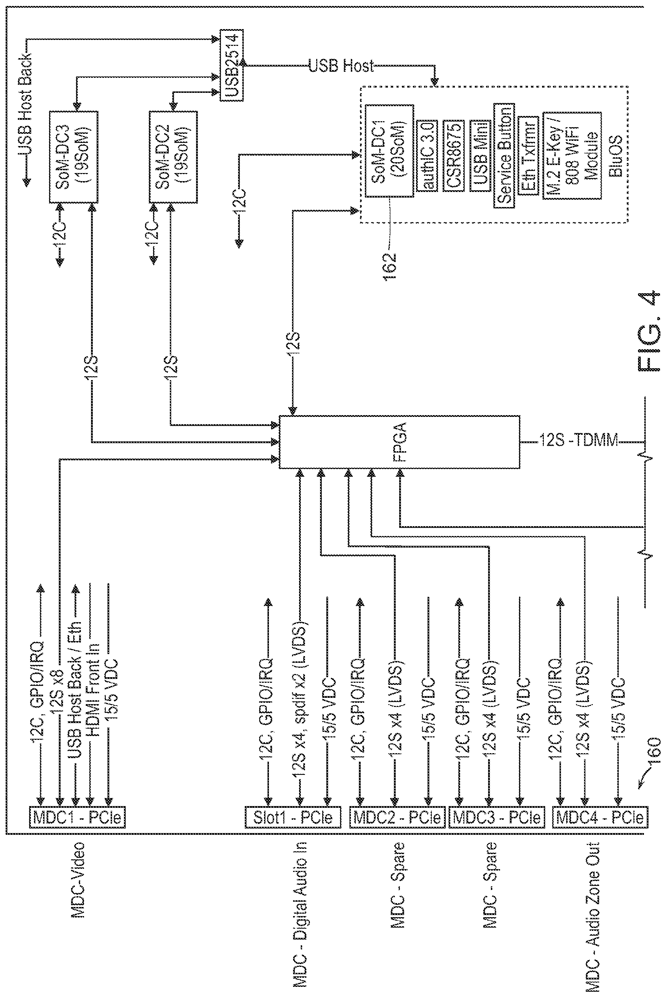

FIG. 4 shows a printed circuit board assembly (PCBA) 160 within the AVR 104, in which the controller 150 is implemented. A microprocessor (SoM-DC1) 162 located on the PCBA 160 is connected to the video switching system circuit board 102 via an Inter-Integrated Circuit (I2C) electrical control bus. All 8K video transceivers 136-148 on the video switching system board 102 are controlled by this microprocessor 162 through the I2C bus. The microprocessor 162 executes an operating system software (identified herein as 'BluOS'), which implements the central video switching controller 150. Each of the video switching system transceiver devices 136-148 can be addressed directly by BluOS through the I2C interface to directly initialize and control each transceiver. After system power-up, BluOS enumerates and confirms the presence of each transceiver device 136-148 in the video switching system.

BluOS evaluates the input connection state of the input-side transceiver devices 136, 138, 140, 142 to confirm which physical HDMI inputs have been connected to a DMS 106. This connection state is determined by reading digital status registers within each transceiver device. HDMI interconnections to external DMS devices 106 are encrypted according to the requirements of Digital Content Protection LLC (DCP). This is performed by the input-side transceivers 136, 138, 140, 142 exchanging security key values with the DMS devices 106 to generate a unique encryption key to 'scramble' digital audio/video data transmitted by the DMS 106.

Through the microprocessor's I2C connection with the output-side transceivers 146, 148, BluOS also enumerates display devices 108 connected to the output-side transceivers 146, 148 via HDMI cable connections. As with the input-side transceivers 136, 138, 140, 142, the connection to each display device 108 is independently validated with DCP security keys to uniquely encrypt and copy-protect the audio/video data transmitted from the output-side transceivers 146, 148 and the connected display devices 108.

While the video switching system 102 is powered, BluOS actively monitors both the input and output side transceivers for HDMI 'hot-plug' events indicated in their on-chip registers. This indicates to BluOS that a user has either connected or disconnected a DMS 106 to either of the input-side transceivers 136, 138, 140, 142 or a display device 108 to the output side transceivers 146, 148. After detection of an HDMI hot-plug event, BluOS re-enumerates the list of DMS devices 106 and display devices 108 connected to the input-side and output-side transceivers.

The BluOS software includes a remote user interface allowing users to view and easily identify each DMS device 106 listed in a custom Android or iOS ('Mobile') app. Alternatively, users may also view list of available DMS devices 106 shown on a TV or projector display device 108 with on-screen display (OSD) graphics. The OSD graphics are generated within BluOS and inserted at 152 into the video switching system 102 with the transceiver 144. The Mobile apps or OSD allow user selection and routing of multiple DMS video streams from its inputs to the system's 'Zone 2' output 130 or its 'Main' zone output 132, 134.

To illustrate how BluOS configures the video switching system's transceivers for concurrently transmitting content from two DMS devices 106 and two display devices 108, consider the following example. A user makes selection in the user-interfaces of either the OSD or Mobile app to display 8K video generated by a game-box on a digital TV 108 connected to the main zone display output 132. In this example, the 8K game-box is connected to HDMI Input 1 (112).

BluOS configures the input-side transceiver 136 to receive game-box video by enabling its first input (the transceiver's second input is not connected but is still actively monitored by BluOS for HDMI hot-plug connection events). As no display devices have been connected to the HDMI 3 Zone 2 output 130, the second output of transceiver 136 is disabled to conserve electrical power. The first output of the transceiver 136 is enabled and configured to pass the game-box's 8K video stream to the next transceiver 146 in the video switching system. Via the I2C connection between the microprocessor 162 and the video switching system 102, BluOS configures the transceiver 146 to pass the game-box video to its single output. The other inputs of this transceiver 146 are not monitored for HDMI hot-plug events, as this transceiver is internal to the system and has no HDMI connections to external DMS devices 106 or display devices 108. BluOS configures the video switching system's final HDMI transceiver 144 to select its first input, receive the 8K game-box video stream data, and relay this data-stream to its first output for transmission through an HDMI cable 132 to the connected display device 108. This HDMI connection to the display device 108 is DCP-encrypted.

After enjoying a video game, the user then pauses the game to connect a second DMS device 106 (in this example, a Blu-ray player) to HDMI Input 5 (120) of the video switching system 102. While the video game is paused, the video switching system 102 continues to pass the video game's paused image through to the first display device. Upon connecting the Blu-ray player to HDMI Input 5 (120), the BluOS controller software queries the status registers of the transceiver 140 and responds to an HDMI hot-plug detect event. The DMS devices 106 are re-enumerated, and the Blu-ray player is added to the list of available DMS devices 106 displayed in the user interfaces of the BluOS Mobile apps and the OSD. The connection between the video switching system 102 and the Blu-ray player is also DCP-authenticated and encrypted.

The user then selects the Blu-ray player in the BluOS Mobile App and selects the HDMI 3 or 'Zone 2' Output 132 as a destination output for the Blu-ray player's video stream. The user notices that no display device is connected to HDMI Zone 2 Output, but sees an available HDMI cable behind the AVR. This is because a professional installer previously mounted an 8K video projector with HDMI cable in an adjacent room that serves as a home theatre. After plugging this cable into the Zone 2 output, a hot-plug event generated by the transceiver 148 causing the BluOS controller software to enumerate the display projector device and add it to the BluOS app's list of display devices. The new projector has valid DCP authentication keys, which it exchanges with the Zone 2 transceiver 148 to establish a fully encrypted connection. The BluOS microprocessor 162 configures the first input of the video transceiver 140 to pass the Blu-ray player content to its second output and onward to the transceiver 148. The output of this output-side transceiver 148 passes the content on to the HDMI Output 3 ('Zone 2') 130.

A second user in the home theater confirms they can see the title screen of a disc inserted in the Blu-ray player connected to the video switching system's Input 5 (120). The first user then confirms they can still see the paused video game on the first display device (the digital TV) and resumes the video game at full 8K video resolution. The second user uses the Blu-ray player's iOS app to initiate playback of the Blu-ray movie title inserted in the Blu-ray player and enjoys the movie at full 8K resolution without interrupting the other user's video game.

Shortly thereafter, the first user recalls that they connected a legacy cable set-top box (STB) via HDMI input 4 (118) because it was listed in the video switching system's OSD. The user then realizes that the set-top box is only capable of 1080p maximum video resolution. This is not an issue for the user, as 1080p resolution is of sufficient quality for the news broadcast she has selected with the STB's remote control. She also uses the BluOS mobile app to select the STB as the input device for the main viewing zone. The associated input-side transceiver 138 of the video switching system 102 has automatically registered this incoming video resolution from the STB and passes the news video stream through the video switching system 102 to the same digital TV that was previously displaying 8K video game content.

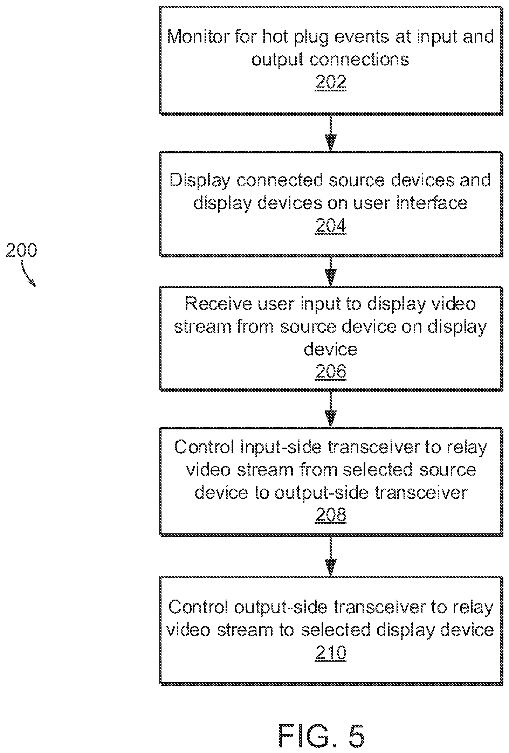

FIG. 5 is a flow chart illustrating an exemplary process 200 implemented in the video switching system 102 to route selected video streams received from digital media sources 106 to selected digital display devices 108.

At step 202, the controller 150 monitors input-side transceiver devices 136-142 for hot plug events at input connections of the AVR 104 to determine connections to digital media sources 106. The controller 150 also monitors output-side transceiver devices 146, 148 for hot plug events to determine connections of display devices 108 to the AVR 104.

At step 204, the controller 150 displays information on the connected source devices 106 and the connected display devices 108 to the user through a user interface.

At step 206, the controller 150 receives through the user interface a user selection to display a video stream from a selected digital media source 106 on a selected display device 108.

At step 208, the controller 150 enables an input of the input-side transceiver 136-142 associated with the selected source device 106 to receive the video stream from the selected source. The controller 150 also enables an output of the input-side transceiver 136-142 to transmit the video stream to the output-side transceiver 146, 148 associated with the selected display device 108.

At step 210, the controller 150 enables an input of the output-side transceiver 146, 148 to receive the video from the input-side transceiver 136-142. The controller 150 also enables an output of the output-side transceiver 146, 148 to relay the video stream to the output of the AVR 104 associated with the selected display device 108 for transmission to the selected display device 108.

The controller 150 can be implemented in a microcontroller, microprocessor, digital signal processor, application-specific integrated circuit (ASIC), field programmable gate arrays (FPGA), or any general-purpose or special-purpose circuitry that can be programmed or configured to perform the functions described herein, including controlling operation of the various transceivers to simultaneously route video streams received at the HDMI connection inputs to the connection outputs.

Each of the transceivers can comprise an ASIC, an application-specific standard product (ASSP), an FPGA, or any general-purpose or special-purpose circuitry that can be programmed or configured to perform the functions described herein, including simultaneously routing video streams received at any of its inputs to any of its outputs.

The processes described above for routing video streams may be implemented in software, hardware, firmware, or any combination thereof. The processes are preferably implemented in one or more computer programs executing on the microprocessor. Each computer program can be a set of instructions (program code) in a code module resident in the random access memory of the microprocessor. Until required by the microprocessor, the set of instructions may be stored in another computer memory or stored on another computer system and downloaded via the Internet or other network.

Having thus described several illustrative embodiments, it is to be appreciated that various alterations, modifications, and improvements will readily occur to those skilled in the art. While some examples presented herein involve specific combinations of functions or structural elements, it should be understood that those functions and elements may be combined in other ways according to the present disclosure to accomplish the same or different objectives. In particular, acts, elements, and features discussed in connection with one embodiment are not intended to be excluded from similar or other roles in other embodiments.

Additionally, elements and components described herein may be further divided into additional components or joined together to form fewer components for performing the same functions.

Accordingly, the foregoing description and attached drawings are by way of example only, and are not intended to be limiting.

## Claims

1. A video-switching system (102) in an audio video receiver (AVR) console, comprising:
a plurality of multimedia interface connection inputs (112, 114, 116, 118, 120, 122, 124, 126) in the AVR console, each being connectable to and for receiving a video stream from one of a plurality of digital media sources;
a set of first transceivers (136, 138, 140, 142, 144) in the AVR console connected to the multimedia interface connection inputs for receiving the video streams from the multimedia interface connection inputs, each first transceiver having a plurality of inputs and a plurality of outputs and being configured to simultaneously route video streams received at any of the inputs to any of the outputs, wherein each multimedia interface connection input is connected to a different one of the inputs of the set of first transceivers;
a set of second transceivers (146, 148) in the AVR console connected to the set of first transceivers for receiving the video streams routed by the first transceivers, each second transceiver having a plurality of inputs and one output and configured for routing video streams received at any one of the plurality of inputs to the one output, wherein an output of each first transceiver is connected to an input of each second transceiver such that each first transceiver can selectively transmit any one of the video streams received at the first transceiver to a selected second transceiver;
a plurality of multimedia interface connection outputs (130, 132) in the AVR console, each connected to the output of a different one of the second transceivers for receiving a video stream from the output of the second transceiver to be displayed on a digital display device removably connectable to that multimedia interface connection output;
an additional multimedia interface connection output (134) and a 2:2 transceiver (144), said 2:2 transceiver having
a first input connected to the output of one of the second transceivers (146, 148) and
a second input (152) connected to an on-screen display video stream providing a graphical user interface to provide system setup and configuration features,
a first output connected to one of the multimedia interface connection outputs (132) and
a second output connected to the additional multimedia interface connection output (134),
wherein said 2:2 transceiver is configured for simultaneously routing video streams received at either of the first and second inputs to either of the multimedia interface connection output and the additional multimedia interface connection output; and
a controller (150) in the AVR console connected to and configured to control operation of each of the first transceivers and each of the second transceivers to simultaneously route video streams received at any of the plurality of multimedia interface connection inputs to any of the plurality of multimedia interface connection outputs and received at the first and second inputs to either of the multimedia interface connection output and the additional multimedia interface connection output.

2. The system (102) of claim 1, wherein the controller (150) in the AVR console is connected to and configured to control operation of each of the first transceivers, each of the second transceivers and the 2:2 transceiver to simultaneously route the video streams.

3. The system (102) of claim 1, wherein the set of first transceivers comprises four 2:2 transceivers (136, 138, 140, 142), each having two inputs and two outputs; and wherein the set of second transceivers comprises two 4:1 transceivers (146, 148) , each having four inputs and one output.

4. The system (102) of claim 1, wherein the multimedia interface connection inputs comprise High-Definition Multimedia Interface (HDMI) inputs, and wherein the multimedia interface connection outputs comprise HDMI outputs.

5. The system (102) of claim 1, further comprising a plurality of static protection devices (128), each connected to one of the plurality of multimedia interface connection inputs (112, 114, 116, 118, 120, 122, 124, 126) to prevent or inhibit damage to components of the system from static electricity.

6. The system (102) of claim 1, wherein the system is implemented in a single electric circuit board.

7. The system (102) of claim 1, wherein the video streams comprise 8K video streams.

8. The system (102) of claim 1, wherein the system is implemented in one or more electric circuit board assemblies.

9. The system (102) of claim 1, wherein the first transceivers (136, 138, 140, 142, 144) and the second transceivers (146, 148) are configured to buffer and reclock video streams to maintain signal integrity.

10. A method of simultaneously routing video signals in a video-switching system in an audio video receiver (AVR) console, comprising the steps of:
(a) receiving a plurality of video streams from a plurality of digital media sources at a plurality of multimedia interface connection inputs (112, 114, 116, 118, 120, 122, 124, 126) in the AVR console;
(b) controlling operation of one or more of a plurality of first transceivers (136, 138, 140, 142, 144) to selectively route the plurality of video streams received at the multimedia interface connection inputs to one or more of a plurality of second transceivers (146, 148) in the AVR console;
(c) controlling operation of the one or more of the plurality of second transceivers to selectively route the plurality of video streams received from the one or more of the plurality of first transceivers to multimedia interface connection outputs (130, 132, 134) in the AVR console to be displayed on digital display devices connected to the multimedia interface connection outputs, such that video streams received at any of the plurality of multimedia interface connection inputs are selectively and simultaneously routed to any of the plurality of multimedia interface connection outputs; and
(d) simultaneously routing, by a 2:2 transceiver having a first input connected to the output of one of the second transceivers (146, 148) and a second input (152) connected to an on-screen display video stream providing a graphical user interface to provide system setup and configuration features, video streams received at either of the first and second inputs to either of one of the multimedia interface connection outputs (132) and an additional multimedia interface connection output (134).

11. The method of claim 10, further comprising monitoring the plurality of first transceivers (136, 138, 140, 142, 144) for hot plug events (112, 114, 116, 118, 120, 122, 124, 126) at the plurality of multimedia interface connection inputs to identify digital media sources connected to the video-switching system (102), and monitoring the plurality of second transceivers (146, 148) for hot plug events wat the plurality of multimedia interface connection outputs (130, 132, 134) to identify display devices connected to the video-switching system.

12. The method of claim 10, further comprising controlling operation of the first transceivers (136, 138, 140, 142, 144) and the second transceivers (146, 148) to buffer and reclock the video streams to maintain signal integrity.

## Patentansprüche

1. Videoumschaltsystem (102) in einer Audio-Video-Receiver-Konsole (AVR), das umfasst:
eine Vielzahl von Multimedia-Schnittstellenanschlusseingängen (112, 114, 116, 118, 120, 122, 124, 126) in der AVR-Konsole, wobei jeder mit einer von einer Vielzahl digitaler Medienquellen verbunden werden kann und dazu dient, einen Videostream von dieser zu empfangen;
einen Satz erster Transceiver (136, 138, 140, 142, 144) in der AVR-Konsole, die mit den Multimedia-Schnittstellenanschlusseingängen verbunden sind, um die Videostreams von den Multimedia-Schnittstellenanschlusseingängen zu empfangen, wobei jeder erste Transceiver eine Vielzahl von Eingängen und eine Vielzahl von Ausgängen aufweist und so konfiguriert ist, dass er an einem beliebigen der Eingänge empfangene Videostreams gleichzeitig an einen beliebigen der Ausgänge weiterleitet, wobei jeder Multimedia-Schnittstellenanschlusseingang mit einem anderen der Eingänge des Satzes erster Transceiver verbunden ist;
eine Gruppe von zweiten Transceivern (146, 148) in der AVR-Konsole, die mit der Gruppe von ersten Transceivern verbunden sind, um die von den ersten Transceivern weitergeleiteten Videostreams zu empfangen, wobei jeder zweite Transceiver mehrere Eingänge und einen Ausgang aufweist und so konfiguriert ist, dass er an einem beliebigen der mehreren Eingänge empfangene Videostreams an den einen Ausgang weiterleitet, wobei ein Ausgang jedes ersten Transceivers mit einem Eingang jedes zweiten Transceivers verbunden ist, so dass jeder erste Transceiver wahlweise einen beliebigen der am ersten Transceiver empfangenen Videostreams an einen ausgewählten zweiten Transceiver übertragen kann;
eine Vielzahl von Multimedia-Schnittstellenanschlussausgängen (130, 132) in der AVR-Konsole, die jeweils mit dem Ausgang eines anderen der zweiten Transceiver verbunden sind, um einen Videostream vom Ausgang des jeweiligen zweiten Transceivers zu empfangen, der auf einem digitalen Anzeigegerät angezeigt werden soll, das abnehmbar mit diesem Multimedia-Schnittstellenanschlussausgang verbunden werden kann;
einen zusätzlichen Multimedia-Schnittstellenanschlussausgang (134) und einen 2:2-Transceiver (144), wobei der 2:2-Transceiver Folgendes aufweist:
einen ersten Eingang, der mit dem Ausgang eines der zweiten Transceiver (146, 148) verbunden ist, und
einen zweiten Eingang (152), der mit einem On-Screen-Display-Videostream verbunden ist, der eine grafische Benutzeroberfläche bereitstellt, um Funktionen zur Systemeinrichtung und -konfiguration bereitzustellen,
einen ersten Ausgang, der mit einem der Multimedia-Schnittstellenanschlussausgänge (132) verbunden ist, und
einen zweiten Ausgang, der mit dem zusätzlichen Multimedia-Schnittstellenanschlussausgang (134) verbunden ist,
wobei der 2:2-Transceiver so konfiguriert ist, dass er an entweder dem ersten oder dem zweiten Eingang empfangene Videostreams gleichzeitig entweder an den Multimedia-Schnittstellenanschlussausgang oder an den zusätzlichen Multimedia-Schnittstellenanschlussausgang weiterleitet; und
eine Steuerung (150) in der AVR-Konsole, die mit jedem der ersten Transceiver und jedem der zweiten Transceiver verbunden und so konfiguriert ist, dass sie deren Betrieb steuert, um Videostreams, die an einem beliebigen der Vielzahl von Multimedia-Schnittstellenanschlusseingänge empfangen werden, gleichzeitig an einen beliebigen der Vielzahl von Multimedia-Schnittstellenanschlussausgänge weiterzuleiten, und um Videostreams, die am ersten und zweiten Eingang empfangen werden, entweder an den Multimedia-Schnittstellenanschlussausgang oder an den zusätzlichen Multimedia-Schnittstellenanschlussausgang weiterzuleiten.

2. System (102) nach Anspruch 1, wobei die Steuerung (150) in der AVR-Konsole mit jedem der ersten Transceiver verbunden und so konfiguriert ist, dass sie deren Betrieb steuert, wobei jeder der zweiten Transceiver und der 2:2-Transceiver die Videostreams gleichzeitig weiterleiten.

3. System (102) nach Anspruch 1, wobei der Satz erster Transceiver vier 2:2-Transceiver (136, 138, 140, 142) umfasst, von denen jeder zwei Eingänge und zwei Ausgänge aufweist; und wobei die Gruppe der zweiten Transceiver zwei 4:1-Transceiver (146, 148) umfasst, von denen jeder vier Eingänge und einen Ausgang aufweist.

4. System (102) nach Anspruch 1, wobei die Multimedia-Schnittstellenanschlusseingänge High-Definition-Multimedia-Interface- (HDMI) Eingänge umfassen, und wobei die Multimedia-Schnittstellenanschlussausgänge HDMI-Ausgänge umfassen.

5. System (102) nach Anspruch 1, das ferner eine Vielzahl von Überspannungsschutzvorrichtungen (128) umfasst, die jeweils mit einem der Vielzahl von Multimedia-Schnittstellenanschlusseingängen (112, 114, 116, 118, 120, 122, 124, 126) verbunden sind, um Schäden an Komponenten des Systems durch statische Elektrizität zu verhindern oder zu unterbinden.

6. System (102) nach Anspruch 1, wobei das System auf einer einzigen elektrischen Leiterplatte implementiert ist.

7. System (102) nach Anspruch 1, wobei die Videostreams 8K-Videostreams umfassen.

8. System (102) nach Anspruch 1, wobei das System in einer oder mehreren elektrischen Leiterplattenbaugruppen implementiert ist.

9. System (102) nach Anspruch 1, wobei die ersten Transceiver (136, 138, 140, 142, 144) und die zweiten Transceiver (146, 148) so konfiguriert sind, dass sie Videostreams puffern und neu takten, um die Signalintegrität aufrechtzuerhalten.

10. Verfahren zum gleichzeitigen Weiterleiten von Videosignalen in einem Videoumschaltsystem in einer Audio-Video-Receiver-Konsole (AVR), das folgende Schritten umfasst:
(a) Empfangen einer Vielzahl von Videostreams von einer Vielzahl digitaler Medienquellen an einer Vielzahl von Multimedia-Schnittstellenanschlusseingängen (112, 114, 116, 118, 120, 122, 124, 126) in der AVR-Konsole;
(b) Steuern des Betriebs eines oder mehrerer einer Vielzahl von ersten Transceivern (136, 138, 140, 142, 144), um die an den Multimedia-Schnittstellenanschlusseingängen empfangene Vielzahl von Videostreams selektiv an einen oder mehrere einer Vielzahl von zweiten Transceivern (146, 148) in der AVR-Konsole weiterzuleiten;
(c) Steuern des Betriebs des einen oder der mehreren der Vielzahl von zweiten Transceivern, um die Vielzahl von Videostreams, die von dem einen oder mehreren der Vielzahl von ersten Transceivern empfangen werden, selektiv an die Multimedia-Schnittstellenanschlussausgänge (130, 132, 134) in der AVR-Konsole weiterzuleiten, damit sie auf digitalen Anzeigegeräten angezeigt werden, die mit den Multimedia-Schnittstellenaschlussausgängen verbunden sind, so dass an einem beliebigen der Vielzahl von Multimedia-Schnittstellenanschlusseingängen empfangene Videostreams selektiv und gleichzeitig an einen beliebigen der Vielzahl von Multimedia-Schnittstellenanschlussausgängen weitergeleitet werden; und
(d) gleichzeitiges Weiterleiten von Videostreams, die an einem der ersten oder zweiten Eingänge empfangen werden, entweder an einen der Multimedia-Schnittstellenanschlussausgänge (132) oder an einen zusätzlichen Multimedia-Schnittstellenanschlussausgang (134), durch einen 2:2-Transceiver, dessen erster Eingang mit dem Ausgang eines der zweiten Transceiver (146, 148) verbunden ist und dessen zweiter Eingang (152) mit einem On-Screen-Display-Videostream verbunden ist, der eine grafische Benutzeroberfläche bereitstellt, um Funktionen zur Systemeinrichtung und -konfiguration bereitzustellen,

11. Verfahren nach Anspruch 10, das ferner das Überwachen der Vielzahl von ersten Transceivern (136, 138, 140, 142, 144) auf Hot-Plug-Ereignisse (112, 114, 116, 118, 120, 122, 124, 126) an der Vielzahl von Multimedia-Schnittstellenanschlusseingängen umfasst, um mit dem Videoumschaltsystem (102) verbundene digitale Medienquellen zu identifizieren, und Überwachen der Vielzahl von zweiten Transceivern (146, 148) auf Hot-Plug-Ereignisse an der Vielzahl von Multimedia-Schnittstellenanschlussausgängen (130, 132, 134), um mit dem Videoumschaltsystem verbundene Anzeigegeräte zu identifizieren.

12. Verfahren nach Anspruch 10, das ferner das Steuern des Betriebs der ersten Transceiver (136, 138, 140, 142, 144) und der zweiten Transceiver (146, 148) umfasst, um die Videostreams zwischenzuspeichern und neu zu takten, um die Signalintegrität aufrechtzuerhalten.

## Revendications

1. Système d'aiguillage vidéo (102) mis en œuvre dans une console de réception audio-vidéo (AVR, audio video receiver), comprenant :
une pluralité d'entrées de connexion d'interface multimédia (112, 114, 116, 118, 120, 122, 124, 126) de la console AVR, chacune pouvant être connectée à une source multimédia numérique d'une pluralité de sources multimédias numériques et pouvant recevoir un flux vidéo de celle-ci,
un ensemble de premiers émetteurs-récepteurs (136, 138, 140, 142, 144) de la console AVR, connectés aux entrées de connexion d'interface multimédia pour recevoir les flux vidéo provenant des entrées de connexion d'interface multimédia, chaque premier émetteur-récepteur comprenant une pluralité d'entrées et une pluralité de sorties et étant conçu pour acheminer simultanément les flux vidéo reçus au niveau de l'une quelconque des entrées vers l'une quelconque des sorties, chaque entrée de connexion d'interface multimédia étant connectée à une entrée différente parmi les entrées de l'ensemble de premiers émetteurs-récepteurs,
un ensemble de deuxièmes émetteurs-récepteurs (146, 148) de la console AVR, connectés à l'ensemble de premiers émetteurs-récepteurs pour recevoir les flux vidéo acheminés par les premiers émetteurs-récepteurs, chaque deuxième émetteur-récepteur comprenant une pluralité d'entrées et une sortie et étant conçu pour acheminer les flux vidéo reçus au niveau de l'une quelconque des entrées vers la sortie, la sortie de chaque premier émetteur-récepteur étant connectée à une entrée de chaque deuxième émetteur-récepteur de telle sorte que chaque premier émetteur-récepteur puisse transmettre sélectivement l'un quelconque des flux vidéo reçus au niveau du premier émetteur-récepteur vers un deuxième émetteur-récepteur sélectionné,
une pluralité de sorties de connexion d'interface multimédia (130, 132) de la console AVR, chacune connectée à la sortie d'un deuxième émetteur-récepteur différent pour recevoir un flux vidéo provenant de la sortie du deuxième émetteur-récepteur afin qu'il soit affiché sur un dispositif d'affichage numérique pouvant être connecté de manière amovible à cette sortie de connexion d'interface multimédia,
une sortie de connexion d'interface multimédia supplémentaire (134) et un émetteur-récepteur 2:2 (144), ledit émetteur-récepteur 2:2 comprenant :
une première entrée connectée à la sortie de l'un des deuxièmes émetteurs-récepteurs (146, 148) et
une deuxième entrée (152) connectée à un flux vidéo pour affichage sur écran fournissant une interface utilisateur graphique permettant d'offrir des fonctionnalités de configuration et de paramétrage du système,
une première sortie connectée à l'une des sorties de connexion d'interface multimédia (132) et
une deuxième sortie connectée à la sortie de connexion d'interface multimédia supplémentaire (134) ;
ledit émetteur-récepteur 2:2 étant conçu pour acheminer simultanément des flux vidéo reçus au niveau des première ou deuxième entrées vers la sortie de connexion d'interface multimédia ou la sortie de connexion d'interface multimédia supplémentaire ; et
un dispositif de commande (150) de la console AVR, connecté à chacun des premiers émetteurs-récepteurs et à chacun des deuxièmes émetteurs-récepteurs et conçu pour commander leur fonctionnement afin d'acheminer simultanément les flux vidéo reçus au niveau de l'une quelconque des entrées de connexion d'interface multimédia vers l'une quelconque des sorties de connexion d'interface multimédia et reçus au niveau de les première et deuxième entrées vers la sortie de connexion d'interface multimédia ou la sortie de connexion d'interface multimédia supplémentaire.

2. Système (102) selon la revendication 1, dans lequel le dispositif de commande (150) de la console AVR est connecté à chacun des premiers émetteurs-récepteurs, à chacun des deuxièmes émetteurs-récepteurs et à l'émetteur-récepteur 2:2 et est conçu pour commander leur fonctionnement afin d'acheminer simultanément les flux vidéo.

3. Système (102) selon la revendication 1, dans lequel l'ensemble de premiers émetteurs-récepteurs comprend quatre émetteurs-récepteurs 2:2 (136, 138, 140, 142), chacun ayant deux entrées et deux sorties, et dans lequel l'ensemble de deuxièmes émetteurs-récepteurs comprend deux émetteurs-récepteurs 4:1 (146, 148), chacun ayant quatre entrées et une sortie.

4. Système (102) selon la revendication 1, dans lequel les entrées de connexion d'interface multimédia comprennent des entrées d'interface multimédia haute définition (HDMI), et dans lequel les sorties de connexion d'interface multimédia comprennent des sorties HDMI.

5. Système (102) selon la revendication 1, comprenant en outre une pluralité de dispositifs de protection statique (128), chacun connecté à l'une des entrées de connexion d'interface multimédia (112, 114, 116, 118, 120, 122, 124, 126) afin d'empêcher ou d'inhiber les dommages causés aux composants du système par l'électricité statique.

6. Système (102) selon la revendication 1, dans lequel le système est mis en œuvre dans une même carte de circuit électrique.

7. Système (102) selon la revendication 1, dans lequel les flux vidéo comprennent des flux vidéo 8K.

8. Système (102) selon la revendication 1, dans lequel le système est mis en œuvre dans une ou plusieurs cartes de circuit imprimé assemblées.

9. Système (102) selon la revendication 1, dans lequel les premiers émetteurs-récepteurs (136, 138, 140, 142, 144) et les deuxièmes émetteurs-récepteurs (146, 148) sont conçus pour mettre en mémoire tampon et resynchroniser les flux vidéo afin de maintenir l'intégrité du signal.

10. Procédé d'acheminement simultané de signaux vidéo dans un système d'aiguillage vidéo d'une console de réception audio-vidéo (AVR, audio video receiver), comprenant les étapes consistant à :
(a) recevoir une pluralité de flux vidéo provenant d'une pluralité de sources multimédias numériques au niveau d'une pluralité d'entrées de connexion d'interface multimédia (112, 114, 116, 118, 120, 122, 124, 126) de la console AVR,
(b) commander le fonctionnement d'un ou de plusieurs premiers émetteurs-récepteurs (136, 138, 140, 142, 144) pour acheminer sélectivement la pluralité de flux vidéo reçus au niveau des entrées de connexion d'interface multimédia vers un ou plusieurs deuxièmes émetteurs-récepteurs (146, 148) de la console AVR,
(c) commander le fonctionnement d'un ou de plusieurs deuxièmes émetteurs-récepteurs pour acheminer sélectivement la pluralité de flux vidéo reçus en provenance du ou des premiers émetteurs-récepteurs vers les sorties de connexion d'interface multimédia (130, 132, 134) de la console AVR pour qu'ils soient affichés sur des dispositifs d'affichage numérique connectés aux sorties de connexion d'interface multimédia, de telle sorte que les flux vidéo reçus au niveau de l'une quelconque des entrées de connexion d'interface multimédia soient acheminés sélectivement et simultanément vers l'une quelconque des sorties de connexion d'interface multimédia, et
(d) acheminer simultanément, au moyen d'un émetteur-récepteur 2:2 ayant une première entrée connectée à la sortie de l'un des deuxièmes émetteurs-récepteurs (146, 148) et une deuxième entrée (152) connectée à un flux vidéo pour affichage sur écran fournissant une interface utilisateur graphique permettant d'offrir des fonctionnalités de configuration et de paramétrage du système, les flux vidéo reçus au niveau des première ou deuxième entrées vers l'une des sorties de connexion d'interface multimédia (132) ou la sortie de connexion d'interface multimédia supplémentaire (134).

11. Procédé selon la revendication 10, comprenant en outre la surveillance de la pluralité de premiers émetteurs-récepteurs (136, 138, 140, 142, 144) pour détecter des événements de branchement à chaud (112, 114, 116, 118, 120, 122, 124, 126) au niveau de la pluralité d'entrées de connexion d'interface multimédia afin d'identifier les sources multimédias numériques connectées au système d'aiguillage vidéo (102), et la surveillance de la pluralité de deuxièmes émetteurs-récepteurs (146, 148) pour détecter des événements de branchement à chaud au niveau de la pluralité de sorties de connexion d'interface multimédia (130, 132, 134) afin d'identifier les dispositifs d'affichage connectés au système d'aiguillage vidéo.

12. Procédé selon la revendication 10, comprenant en outre la commande du fonctionnement des premiers émetteurs-récepteurs (136, 138, 140, 142, 144) et des deuxièmes émetteurs-récepteurs (146, 148) pour mettre en mémoire tampon et resynchroniser les flux vidéo afin de maintenir l'intégrité du signal.
